# EUROPEAN PATENT APPLICATION

(11) **EP 3 154 087 A1**
(43) Date of publication of application: **12.04.2017**
(21) Application number: 14882149.9
(22) Date of filing: 28.10.2014
(51) Int. Cl.: H01L 27/32, H01L 21/82

(54) **OLED UNIT AND FABRICATION METHOD THEREFOR, OLED DISPLAY PANEL AND OLED DISPLAY APPARATUS**

(30) Priority: 02.07.2014 CN 201410311911
(71) Applicant: BOE Technology Group Co., Ltd., Beijing 100015 (CN)
(72) Inventor: WANG, Jiliang, Beijing 100176 (CN); LEE, Chung-Chun, Beijing 100176 (CN)
(74) Representative: Pierrou, Mattias
(86) International application number: PCT/CN2014/089674
(87) International publication number: WO 2016/000364

(57) **Abstract**

The present invention discloses an OLED unit and a manufacturing method thereof, an OLED display panel and an OLED display apparatus. The OLED unit comprises a plurality of pixel regions each comprising: a first electrode layer and a second electrode layer; at least two light-emitting units stacked between the first electrode layer and the second electrode layer; and a color filter layer formed on a surface of the first electrode layer or the second electrode layer opposite to the light-emitting units. The at least two light-emitting units comprise: a first monochromatic light-emitting unit located throughout the pixel region and configured to emit light at a first sub-pixel region of the pixel region; and other light-emitting units located on the first monochromatic light-emitting unit and configured to correspond to the other sub-pixel regions other than the first sub-pixel region. Manufacturing difficulty of the OLED device is decreased, and power consumption of the OLED display apparatus is also reduced.

## Description

### BACKGROUND OF THE INVENTION

### Field of the Invention

The present disclosure relates to a technical field of display, in particular, relates to an OLED unit and a manufacturing method thereof, an OLED display panel and an OLED display apparatus.

### Description of the Related Art

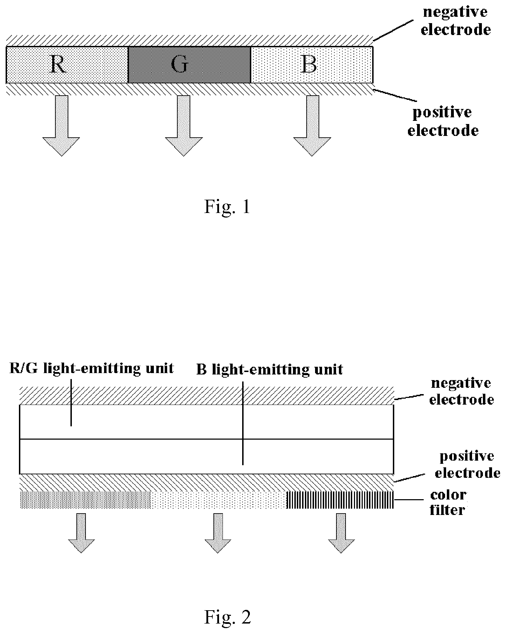

Currently, organic layers of Organic Light Emitting Diode (OLED) devices are commonly manufactured using vacuum evaporation method. For small-sized devices, sub-pixels having three colors R, G, B are generally arranged in parallel mode, as shown in Fig. 1. When manufacturing such an OLED device, a sub-pixel having a first color is firstly evaporated by a high-precision metal mask, and a sub-pixel having a second color is then evaporated after moving the high-precision metal mask to a certain position or replacing by another high-precision metal mask, and a sub-pixel having a third color is manufactured in turn, thus achieving manufacture of one pixel cell. However, with the improvement of the resolution, it is necessary to manufacture more pixel cells on a display screen with the same size, which leads to increasing difficulty in aligning high-precision metal mask.

For a large-sized display device, since a high-precision metal mask may be deformed due to gravity, thereby may be prone to dislocation, it is common to firstly evaporate a white organic layer using an opening mask, then combine with RGB color filters to achieve full color. To achieve a high luminous efficiency, a white light emitting layer is formed by stacking two or more light-emitting units capable of covering white waveband, as shown in Fig. 2, other than by one layer of white material. As waveband range and luminous efficiency of luminescent material are variable, it is common to use red and green luminescent material as one light-emitting unit (R/G light-emitting unit), which is made of phosphorescent material with high efficiency, and use blue luminescent material as one light-emitting unit (B light-emitting unit), which is made of fluorescent material with low efficiency. The two light-emitting units are connected with each other in series between negative and positive electrodes by an electric charge generation layer. When current passing through, the light emitted by the two light-emitting units are combined to form white light, and then passes through three color filters (R, G, B) to generate RGB primary colors. However, in such structure, when white light passes through the three color filters, a part of the white light will be filtered out, which, however, still consumes energy, as a result, power consumption for the devices becomes large.

### SUMMARY OF THE INVENTION

In view of this, the present disclosure provides an OLED unit and a manufacturing method thereof, a display panel and a display apparatus.

According to an aspect of the present disclosure, there is provided an OLED unit comprising a plurality of pixel regions each comprising: a first electrode layer and a second electrode layer; at least two light-emitting units stacked between the first electrode layer and the second electrode layer; and a color filter layer formed on a surface of the first electrode layer or the second electrode layer facing away from the light-emitting units. The at least two light-emitting units comprise: a first monochromatic light-emitting unit located throughout the pixel region and configured to emit light in a first sub-pixel region of the pixel region; and other light-emitting units located on the first monochromatic light-emitting unit and configured to correspond to the other sub-pixel regions other than the first sub-pixel region.

In an OLED unit in accordance with one embodiment of the present invention, the color filter layer is formed on the other sub-pixel regions.

In an OLED unit in accordance with one embodiment of the present invention, the color filter layer is formed on parts of the other sub-pixel regions.

In an OLED unit in accordance with one embodiment of the present invention, the at least two light-emitting units are stacked to emit white light.

In an OLED unit in accordance with one embodiment of the present invention, the other light-emitting units of the at least two light-emitting units comprise polychromatic light-emitting units.

In an OLED unit in accordance with one embodiment of the present invention, the other light-emitting units of the at least two light-emitting units comprise monochromatic light-emitting units.

In an OLED unit in accordance with one embodiment of the present invention, the first monochromatic light-emitting unit is one of red, green and blue light-emitting units, and the other light-emitting units are monochromatic light-emitting units or polychromatic light-emitting units corresponding to the other two colors.

In an OLED unit in accordance with one embodiment of the present invention, the first monochromatic light-emitting unit comprises a blue light-emitting unit, and the other light-emitting units of the at least two light-emitting units comprise monochromatic light-emitting units or polychromatic light-emitting units corresponding to red and green.

In an OLED unit in accordance with one embodiment of the present invention, the OLED unit further comprises: a charge generation layer for connecting the at least two light-emitting units in series.

According to a further aspect of the present disclosure, there is provided an OLED display panel comprising the OLED unit according to the various embodiments described above.

According to a still further aspect of the present disclosure, there is provided an OLED display apparatus comprising the OLED display panel according to the embodiment described above.

According to a yet further aspect of the present disclosure, there is provided a manufacturing method of an OLED unit comprising a plurality of pixel regions, the method comprising steps of:
forming a first monochromatic light-emitting unit on a first electrode layer, so that the first monochromatic light-emitting unit is located throughout the pixel region to emit light at a first sub-pixel region within the pixel region;
forming other light-emitting units stacked on the first monochromatic light-emitting unit, so that the other light-emitting units correspond to the other sub-pixel regions other than the first sub-pixel region;
forming a second electrode layer on the other light-emitting units and the first monochromatic light-emitting unit, on which there is no the other light-emitting units stacked; and
forming a color filter layer on a surface of the first electrode layer or the second electrode layer.

In a manufacturing method of an OLED unit in accordance with one embodiment of the present invention, the first monochromatic light-emitting unit is formed on the first electrode layer by an opened mask.

In a manufacturing method of an OLED unit in accordance with one embodiment of the present invention, the other light-emitting units are stacked on the first monochromatic light-emitting unit by a high-precision metal mask.

A manufacturing method of an OLED unit in accordance with one embodiment of the present invention further comprises steps of: forming a charge generation layer on the first monochromatic light-emitting unit, and forming the other light-emitting units on the charge generation layer.

In a manufacturing method of an OLED unit in accordance with one embodiment of the present invention, the color filter layer is formed on the other sub-pixel regions.

In the above-mentioned technical solutions of the present disclosure, since one light-emitting unit of the OLED unit is formed by an opened mask, it needs for less high-precision metal masks, thereby reduces process difficulty. Furthermore, as for manufacturing of the other light-emitting units, since the opened area of the high-precision metal mask corresponds to a plurality of sub-pixel regions, that is to say, the opened area increases, thereby it is easy to achieve manufacturing of the display panel with high resolution. In addition, since one sub-pixel of the OLED unit manufactured according to the present disclosure needs only one light-emitting unit, and there is no need for color filter cells to filter light, thus overcoming high power consumption defect.

### BRIEF DESCRIPTION OF THE DRAWINGS

Fig. 1 is a schematic structural view showing an OLED unit according to a first prior art;
Fig. 2 is a schematic structural view showing an OLED unit according to a second prior art;
Fig. 3 is a partial sectional view schematically showing an OLED unit according to a first embodiment of the present invention;
Fig. 4 is a partial sectional view schematically showing a RGBW-type OLED unit according to a second embodiment of the present invention;
Fig. 5 is a flow chart illustrating a manufacturing method of the OLED unit according to the first embodiment of the present invention;
Fig. 6 is a flow chart illustrating a manufacturing method of the RGBW-type OLED unit according to the second embodiment of the present invention.

### DETAILED DESCRIPTION OF PREFERRED EMBODIMENTS OF THE INVENTION

In order to present the objective, the technical solutions, and the advantages of the present disclosure more apparently, the embodiments of the present invention will be further explained below with reference to the figures and examples.

Each pixel region or pixel cell in an OLED display device generally comprises a plurality of sub- pixels, each of which may emit lights having different colors, thus to provide light with a variety of colors in the same pixel region. For RGB display device, each pixel region corresponds to three sub-pixels, i.e. red, green and blue sub-pixels, respectively. The present disclosure provides an OLED unit corresponding to one pixel region, i.e., one pixel cell, which is formed by a plurality of light-emitting units stacked in a vertical direction between a negative electrode layer and a positive electrode layer. The plurality of light-emitting units are stacked together to emit white light, such white light is filtered by a color filter layer provided on an outer surface of the negative electrode layer or the positive electrode layer, thus forming sub-pixels capable of emitting light having different colors. A first sub-pixel region in the present disclosure is formed only by one monochromatic light-emitting unit, that is, there is only one monochromatic light-emitting unit in the first sub-pixel region, while other light-emitting units stacked on the monochromatic light-emitting unit is only formed in the other sub-pixel regions, and it is unnecessary for the other sub-pixel regions to provide a color filter layer to filter light, which may therefore reduce power consumption. The technical solutions of the present disclosure will be described in detail below.

The present disclosure provides an OLED unit comprising a plurality of pixel regions, each comprising: at least two light-emitting units, a first electrode layer, a second electrode layer and a color filter layer. The at least two light-emitting units are stacked between the first electrode layer and the second electrode layer, and the color filter layer is formed on a surface of the first electrode layer or the second electrode layer opposite to the light-emitting units. The at least two light-emitting units comprise a first monochromatic light-emitting unit and other light-emitting units. The first monochromatic light-emitting unit is located throughout the pixel region and configured to emit light at a first sub-pixel region of the pixel region; and the other light-emitting units of the at least two light-emitting units are located on the first monochromatic light-emitting unit and configured to correspond to the other sub-pixel regions other than the first sub-pixel region.

In one embodiment, the color filter layer is formed on the other sub-pixel regions; the first electrode layer and the second electrode layer are a negative electrode layer and a positive electrode layer, respectively, the corresponding relationship therebetween may be set according to the actual construction.

In the above-described OLED unit provided in the present disclosure, the first sub-pixel region corresponding to the first monochromatic light-emitting unit includes only the negative electrode layer, the first monochromatic light-emitting unit and the positive electrode layer. During emitting light corresponding to the color of the first monochromatic light-emitting unit, only the first monochromatic light-emitting unit is required to work without a need for a color filter layer to filter light, thus reducing power consumption largely.

By way of example, an OLED display device for providing three RGB colors of light is presented below, to describe the construction of the OLED unit of the present disclosure in detail.

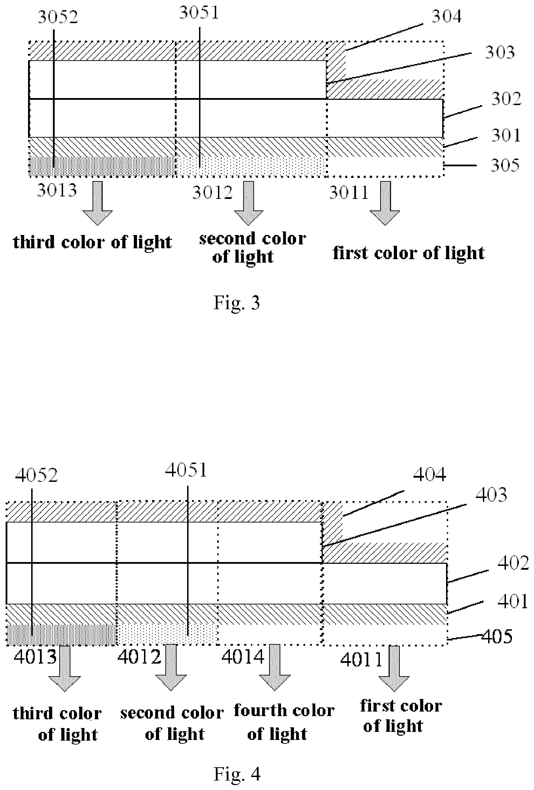

Fig. 3 shows schematically a partial sectional view of an OLED unit according to a first embodiment of the present invention. As shown in Fig. 3, the OLED unit comprises a first electrode layer 301, a first light-emitting unit 302, a second light-emitting unit 303, and a color filter layer 305.

The first electrode layer 301 is located throughout the pixel region, and the total pixel region corresponds to three sub-pixel regions (as shown in dashed boxes in Figure 3), i.e., a first sub-pixel region 3011, a second sub-pixel region 3012 and a third sub-pixel region 3013, respectively. The first sub-pixel region 3011 accordingly generates a first color of light, the second sub-pixel region 3012 accordingly generates a second color of light, and the third sub-pixel region 3013 accordingly generates a third color of light. The first color of light, the second color of light and the third color of light are one of red, green and blue light, respectively.

The first light-emitting unit 302 is provided on an upper surface of the first electrode layer 301, and located throughout the pixel region; the first light-emitting unit 302 is constructed to emit the first color of light corresponding to the first sub-pixel region 3011, which may be emitted out of the OLED unit from the first sub-pixel region 3011.

The second light-emitting unit 303 is stacked on an upper surface of the first light-emitting unit 302, and located on the second sub-pixel region 3012 and the third sub-pixel region 3013; the second light-emitting unit 303 is constructed to emit mixed light having the second color and the third color. The second light-emitting unit 303 is formed on the first light-emitting unit 302 and configured to correspond to the second sub-pixel region 3012 and the third sub-pixel region 3013 other than the first sub-pixel region 3011.

Optionally, the first light-emitting unit 302 is a light-emitting unit for emitting blue light, and the second light-emitting unit 303 is a light-emitting unit for emitting the mixed light with red and green.

A second electrode layer 304 is provided on an upper surface of the second light-emitting unit 303 and the upper surface of the first light-emitting unit, which is not covered by the second light-emitting unit 303.

The color filter layer 305 is provided on a lower surface of the first electrode layer 301, and includes a first color filter cell 3051 and a second color filter cell 3052 located in the second sub-pixel region 3012 and the third sub-pixel region 3013, respectively. The first color filter cell 3051 is used to filter out light other than the second color of light, so as to allow only the second color of light to pass through, and the second color filter cell 3052 is used to filter out light other than the third color of light, so as to allow only the third color of light to pass through.

The above described OLED structure shown in FIG. 3 is formed as a bottom-emission structure, of which the three sub-pixel regions generate the first color of light, the second color of light and the third color of light, respectively, wherein the first color of light is emitted directly by the first light-emitting unit 302. When the corresponding pixel region of the OLED unit emits the first color of light, only the first light-emitting unit 302 is required to work without a need for a color filter layer to filter light, thus reducing power consumption.

For top-emission structure, the color filter layer 305 is located on an upper surface of the second electrode layer 304, from which lights having the three colors are emitted.

The first electrode layer 301 and the second electrode layer 304 are used as a positive electrode layer and a negative electrode layer, respectively, and the corresponding relationship therebetween may be set according to the actual condition. For bottom-emission structure, the first electrode layer 301 may be used as a transparent positive electrode, and made of a metal or metal alloy , such as Al, Mg, Ca, Li, Yb, Mg:Ag, Yb:Ag, Mg/Ag, Yb/Ag, Li/Ag, Al/Ag, Ca/Ag and the like. Such electrode needs to have good electrical conductivity, good transmittance, good chemical and morphological stability, etc. The second electrode layer 304 may be used as a negative electrode with good reflectivity and light-proof characteristic, and made of a metal or metal alloy, such as Ag, Au, Pd, Pt, Ag:Au, Ag:Pd, Ag:Pt, Al:Au, Al:Pd, Al:Pt, Ag:Au, Au/Ag, Pd/Ag, Pt/Ag and the like. Such electrode needs to have good electrical conductivity, good reflectivity, good chemical and morphological stability, etc.

For top-emission structure, the first electrode layer 301 may be used as a positive electrode with high reflectivity and light-proof characteristic, and made of a metal or metal alloy, such as Ag, Au, Pd, Pt, Ag:Au, Ag:Pd, Ag:Pt, Al:Au, Al:Pd, Al:Pt, Ag:Au, Au/Ag, Pd/Ag, Pt/Ag and the like. Such electrode needs to have good electrical conductivity, high reflectivity, good chemical and morphological stability, etc. The second electrode layer 304 may be used as a transparent negative electrode, and made of a metal or metal alloy, such as Al, Mg, Ca, Li, Yb, Mg:Ag, Yb:Ag, Mg/Ag, Yb/Ag, Li/Ag, Al/Ag, Ca/Ag and the like. Such electrode needs to have good electrical conductivity, good transmittance, good chemical and morphological stability, etc.

By way of example, an OLED display device for providing lights having four RGBW colors is presented below, to describe the construction of the OLED unit of the present disclosure in detail.

Fig. 4 shows schematically a partial sectional view of a RGBW-type OLED unit according to a second embodiment of the present invention. As shown in Fig. 4, the RGBW-type OLED unit comprises a first electrode layer 401, a first light-emitting unit 402, a second electrode layer 404, and a color filter layer 405.

The first electrode layer 401 is located throughout the pixel region, and the total pixel region corresponds to four sub-pixel regions (as shown in dashed boxes in Figure), i.e., a first sub-pixel region 4011, a second sub-pixel region 4012, a third sub-pixel region 4013 and a fourth sub-pixel region 4014, respectively. The first sub-pixel region 4011 accordingly generates a first color of light, the second sub-pixel region 4012 accordingly generates a second color of light, the third sub-pixel region 4013 accordingly generates a third color of light, and the fourth sub-pixel region 4014 accordingly generates a fourth color of light. The first color of light, the second color of light and the third color of light are one of red, green and blue light, respectively; and the fourth color of light is white light.

The first light-emitting unit 402 is provided on an upper surface of the first electrode layer 401, and located throughout the pixel region; the first light-emitting unit 402 is constructed to emit the first color of light corresponding to the first sub-pixel region 4011, which may be emitted out of the OLED unit from the first sub-pixel region 4011.

The second light-emitting unit 403 is stacked on an upper surface of the first light-emitting unit 402, and located on the second sub-pixel region 4012, the third sub-pixel region 4013 and the fourth sub-pixel region 4014; the second light-emitting unit 403 constructed to emit mixed light having the second color and the third color, and the second light-emitting unit 403 and the first light-emitting unit 402 are stacked to generate white light. The second light-emitting unit 403 is formed on the first light-emitting unit 402 and configured to correspond to the second sub-pixel region 4012, the third sub-pixel region 4013 and the fourth sub-pixel region 4014 other than the first sub-pixel region 4011.

Optionally, the first light-emitting unit 402 is a light-emitting unit for emitting blue light, and the second light-emitting unit 403 is a light-emitting unit for emitting the mixed light with red and green.

A second electrode layer 404 is provided on an upper surface of the second light-emitting unit 403 and the upper surface of the first light-emitting unit, which is not covered by the second light-emitting unit 403.

The color filter layer 405 is provided on a lower surface of the first electrode layer 401, and includes a first color filter cell 4051 and a second color filter cell 4052 located in the second sub-pixel region 4012 and the third sub-pixel region 4013, respectively. The first color filter cell 4051 is used to filter out light other than the second color of light, so as to allow only the second color of light to pass through, and the second color filter cell 4052 is used to filter out light other than the third color of light, so as to allow only the third color of light to pass through.

The above described RGBW-type OLED unit shown in FIG. 4 is formed as a bottom-emission structure, of which the four sub-pixel regions generate the first color of light, the second color of light, the third color of light and the fourth color of light, respectively, wherein the first color of light is emitted directly by the first light-emitting unit 402, and white light is emitted by stacking the first light-emitting unit and the second light-emitting unit, there is no need for a color filter layer to filter both the first color of light and the white light, thus reducing power consumption loss.

For top-emission structure, the color filter layer 405 is located on an upper surface of the second electrode layer 404, from which the four colors of light is emitted.

The first electrode layer 401 and the second electrode layer 404 are used as a positive electrode layer and a second electrode layer, respectively, and the corresponding relationship therebetween may be set according to the actual condition.

In the above described first and second embodiments shown in FIG. 3 and FIG. 4, the second light-emitting unit 303/403 may be provided as a polychromatic light-emitting unit, i.e., a light-emitting unit capable of emitting two colors of light simultaneously, or may be formed by stacking two monochromatic light-emitting units together, i.e., by stacking two light-emitting units for emitting different colors of light respectively. Obviously, for other type OLED unit other than RGB-type and RGBW-type, the second light-emitting unit may be provided as a polychromatic light-emitting unit capable of emitting more than two colors of light, or may be formed by stacking more than two monochromatic light-emitting units together. For RGBW-type OLED unit, the first light-emitting unit and the second light-emitting unit may be stacked to emit the white light.

Optionally, the polychromatic light-emitting unit includes a hole transportation layer, a polychromatic light-emitting layer and an electron transportation layer, and the polychromatic light-emitting layer is made of luminescent material capable of emitting multiple colors of light, such as phosphorescent material, for emitting red and green light. The monochromatic light-emitting unit includes a hole transportation layer, a monochromatic light-emitting layer and an electron transportation layer, and the monochromatic light-emitting layer is made of luminescent material capable of emitting one color of light, such as fluorescent material, for emitting blue light. Since the light-emitting properties of the fluorescent material for emitting blue light are slightly worse than the light-emitting properties of the phosphorescent material for emitting red and green light, if the light-emitting unit for emitting red and blue light or blue and green light is made by blue light material, and red light material or green light material, it may obtain very weak blue light when using a color filter to filter light, resulting in low luminous efficiency of blue pixels, thereby affecting display effect of the entire display panel.

Optionally, in order to improve luminous efficiency of the OLED device, a charge generation layer for connecting the first light-emitting unit 302/402 and the second light-emitting unit 303/403 in series may also be provided. The charge generation layer provides an electron injecting function in the electron transportation layer of the light-emitting unit, and provides a hole injection function in the hole transportation layer. The charge generation layer, which needs to meet electric conductive and light-transmitting requirements, is generally constituted by a metal film, an ITO conductive film, an organic electronic doped film, etc., having high electric conductivity. For example, WO3 with high transparency is available since it is easy to be manufactured by evaporation, and it may effectively produce and inject holes

Alternatively, the position relationship of the first light-emitting unit and the second light-emitting unit is not limited to the above-mentioned forms in the first and second embodiments, and the first light-emitting unit may be stacked on the upper surface of the second light-emitting unit.

The present disclosure further provides an OLED display device comprising the above described OLED unit.

The present disclosure further provides a method of manufacturing an OLED unit comprising a plurality of pixel regions, the method comprising steps of:
forming a first monochromatic light-emitting unit on a first electrode layer, and locating the first monochromatic light-emitting unit throughout the pixel region to emit light at a first sub-pixel region within the pixel region;
forming other light-emitting units stacked on the first monochromatic light-emitting unit, the other light-emitting units corresponding to the other sub-pixel regions other than the first sub-pixel region;
forming a second electrode layer on the other light-emitting units and the first monochromatic light-emitting unit, on which there is no the other light-emitting units stacked; and
forming a color filter layer on a surface of the first electrode layer or the second electrode layer, wherein the color filter layer is formed on the other sub-pixel regions.

A method of manufacturing the OLED unit will be described in detail below in connection with the above described embodiments shown in FIG. 3 and FIG. 4.

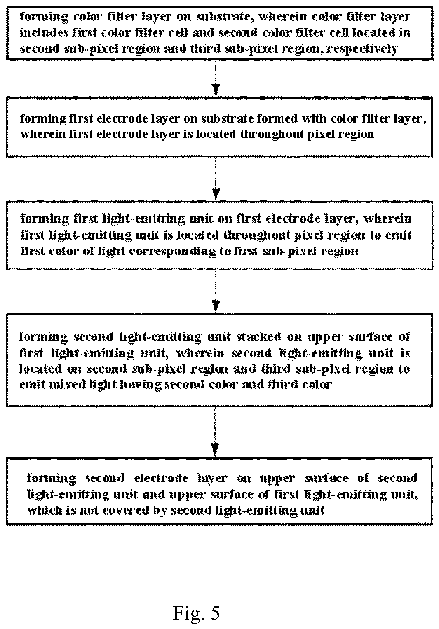

Fig. 5 shows a flow chart of the method of manufacturing the OLED unit according to the first embodiment of the present invention, the OLED unit includes a plurality of pixel regions each including a first sub-pixel region 3011, a second sub-pixel region 3012 and a third sub-pixel region 3013. Referring to Figs. 3 and 5, the method comprises steps of:
Step 501: forming a color filter layer 305 on a substrate, wherein the color filter layer 305 includes a first color filter cell 3051 and a second color filter cell 3052 located in the second sub-pixel region 3012 and the third sub-pixel region 3013, respectively. The first sub-pixel region 3011 accordingly generates a first color of light, the second sub-pixel region 3012 accordingly generates a second color of light, and the third sub-pixel region 3013 accordingly generates a third color of light. The first color of light, the second color of light and the third color of light are one of red, green and blue light, respectively. The first color filter cell 3051 is used to filter out light other than the second color of light, so as to allow only the second color of light to pass through, and the second color filter cell 3052 is used to filter out light other than the third color of light, so as to allow only the third color of light to pass through;
Step 502: forming a first electrode layer 301 on the substrate formed with the color filter layer 305, wherein the first electrode layer 301 is located throughout the pixel region, and the first electrode layer 301 may be used as a negative electrode layer or a positive electrode layer;
Step 503: forming a first light-emitting unit 302 on the first electrode layer 301, wherein the first light-emitting unit 302 is located throughout the pixel region, and the first light-emitting unit 302 is used for emitting the first color of light corresponding to the first sub-pixel region 3011;
Step 504: forming a second light-emitting unit 303 stacked on the upper surface of the first light-emitting unit 302, wherein the second light-emitting unit 303 is located on the second sub-pixel region 3012 and the third sub-pixel region 3013, and the second light-emitting unit 303 is used for emitting mixed light having the second color and the third color;
Step 505: forming a second electrode layer 304 on the upper surface of the second light-emitting unit 303 and the upper surface of the first light-emitting unit 302, which is not covered by the second light-emitting unit 303, and the second electrode layer 304 is used as a positive electrode layer or a negative electrode layer different from the first electrode layer 301.

In the above described method, the color filter layer 305 may be obtained by forming the first color filter cell 3051 and the second color filter cell 3052 on a glass substrate in turn, in exposure and development way; in this step, only two color filter cells for two sub-pixel regions are necessary to be manufactured, rather than three color filter cells for all three sub-pixel regions.

In the step 503, the first light-emitting unit 302 may be manufactured using a mask having an opening, without using high-precision metal masks as used in conventional process. Since the process requirement for the high precision metal masks is rigorous, and has high cost, in the steps of the present disclosure, the process of using high-precision metal masks is eliminated, to a certain extent, it reduces manufacturing difficulty and manufacturing costs.

In step 504, the second light-emitting unit 303 may be manufactured in the second and third sub-pixel regions in an evaporation way, using a high-precision metal mask.

The first electrode layer 301 and the second electrode layer 304 may still be manufactured using a mask having an opening. For bottom-emission structure, the first electrode layer 301 may be made of metal or metal alloy material with high transparency, high electrical conductivity, and the second electrode layer 304 may be made of metal or metal alloy material with high reflectivity, high electrical conductivity. For top-emission structure, the first electrode layer 301 may be made of metal or metal alloy material with high reflectivity, high electrical conductivity, and the second electrode layer 304 may be made of metal or metal alloy material with high transparency, high electrical conductivity.

In the above described manufacturing method, at least one light-emitting unit is manufactured using an opened mask, furthermore, when manufacturing the second light-emitting unit using a high-precision metal mask, the area of the opening portion corresponds to that of two sub-pixel regions, thus achieving higher resolution easily.

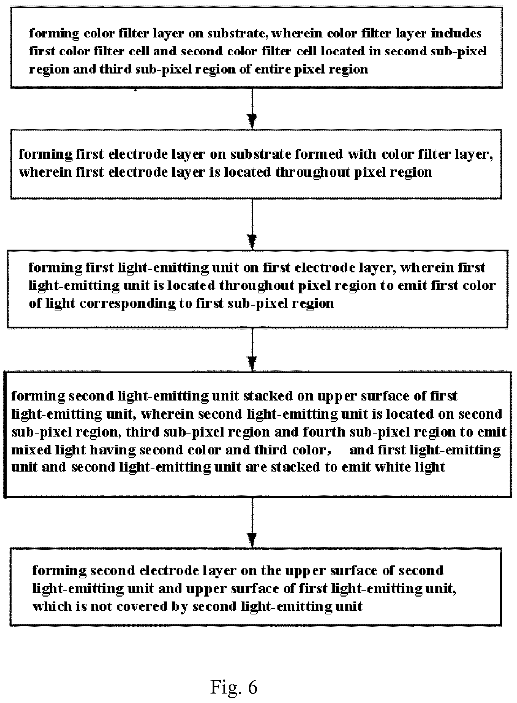

Fig. 6 shows a flow chart of a method of manufacturing the RGBW-type OLED unit according to the second embodiment of the present invention. Referring to Figs. 4 and 6, the OLED unit includes a plurality of pixel regions each including a first sub-pixel region 4011, a second sub-pixel region 4012, a third sub-pixel region 4013 and a fourth sub-pixel region 4014. The method comprises steps of:
Step 601: forming a color filter layer 405 on a substrate, wherein the color filter layer 405 includes a first color filter cell 4051 and a second color filter cell 4052 located in the second sub-pixel region 4012 and the third sub-pixel region 4013 of the entire pixel region, to which the OLED unit corresponds, respectively; the first sub-pixel region 4011 accordingly generates a first color of light, the second sub-pixel region 4012 accordingly generates a second color of light, the third sub-pixel region 4013 accordingly generates a third color of light respectively, and the fourth sub-pixel region 4014 accordingly generates a fourth color of light; the first color of light, the second color of light and the third color of light are one of red, green and blue light, respectively; the first color filter cell 4051 is used to filter out light other than the second color of light, so as to allow only the second color of light to pass through, and the second color filter cell 4052 is used to filter out light other than the third color of light, so as to allow only the third color of light to pass through;
Step 602: forming a first electrode layer 401 on the substrate formed with the color filter layer 405, wherein the first electrode layer 401 is located throughout the pixel region ,and the first electrode layer 401 may be used as a negative electrode layer or a positive electrode layer;
Step 603: forming a first light-emitting unit 402 on the first electrode layer 401, wherein the first light-emitting unit 402 is located throughout the pixel region, and the first light-emitting unit 402 is used for emitting the first color of light corresponding to the first sub-pixel region 4011;
Step 604: forming a second light-emitting unit 403 stacked on the upper surface of the first light-emitting unit 402, wherein the second light-emitting unit 403 is located on the second sub-pixel region 4012, the third sub-pixel region 4013 and the fourth sub-pixel region 4014, and the second light-emitting unit 403 is used for emitting mixed light having the second color and the third color; the first light-emitting unit 402 and the second light-emitting unit 403 are stacked to emit white light;
Step 605: forming a second electrode layer 404 on the upper surface of the second light-emitting unit 403 and the upper surface of the first light-emitting unit 402, which is not covered by the second light-emitting unit 403, wherein the second electrode layer 404 is used as a positive electrode layer or a negative electrode layer different from the first electrode layer 401.

In the above described method, the color filter layer 405 may be obtained by forming the first color filter cell 4051 and the second color filter cell 4052 on a glass substrate in turn, in exposure and development way; in this step, only two color filter cells for two sub-pixel regions are necessary to be manufactured, rather than three color filter cells for all three sub-pixel regions, and it is unnecessary to manufacture color filter cells in white light sub-pixel region.

The manufacturing process of this RGBW-type OLED unit is substantially identical to that of the OLED unit according to the first embodiment, the difference therebetween lies in that the first light-emitting unit and the second light-emitting unit of the RGBW-type OLED unit are formed by stacking material capable of emitting white light, and it is unnecessary to form color filter layers for the sub-pixel region corresponding to the first light-emitting unit and the white light to.

The two above described manufacturing method further comprises steps of: forming a charge generation layer on the first light-emitting unit, and forming the second light-emitting unit on the charge generation layer. The charge generation layer, which needs to meet electric conductive and light-transmitting requirements, may generally be made of a metal film, an ITO conductive film, an organic electronic doped film, etc., having high electric conductivity.

Alternatively, in the manufacturing method of the OLED unit according to the above described first and second embodiments, the second light-emitting unit may be manufactured firstly such that the second light-emitting unit is located on parts of the sub-pixel regions, then the first light-emitting unit is stacked on the second light-emitting unit such that the first light-emitting unit is located throughout the pixel region.

In the manufacturing method of the OLED unit according to the present disclosure, since one light-emitting unit is formed by an opened mask, it needs for less high-precision metal masks, thereby reduces process difficulty. Furthermore, as for manufacturing of the other light-emitting units, since the opening area of the high-precision metal mask corresponds to a plurality of sub-pixel regions, that is to say, the opened area is larger than the opening area in the conventional process as shown in Fig. 1, thereby it is easy to achieve manufacturing of the display panel with high resolution. In addition, since one sub-pixel of the OLED unit manufactured according to the present disclosure needs only one light-emitting unit, and there is no need for color filter cells to filter light, thus overcoming high power consumption defect.

The objective, the technical solutions, and the advantages of the present disclosure have been further described in detail with reference to the above described specific embodiments, it should be understood that the above description is only the specific embodiment of the present invention, but not to limit the present invention, any modifications, equivalents, improvements and the like within the spirit and principle of the present invention are falling into the scope of the present invention.

## Claims

1. An OLED unit comprising a plurality of pixel regions each comprising:
a first electrode layer and a second electrode layer;
at least two light-emitting units stacked between the first electrode layer and the second electrode layer; and
a color filter layer formed on a surface of the first electrode layer or the second electrode layer facing away from the light-emitting units; wherein, the at least two light-emitting units comprise:
a first monochromatic light-emitting unit located throughout the pixel region and configured to emit light in a first sub-pixel region of the pixel region; and
other light-emitting units located on the first monochromatic light-emitting unit and configured to correspond to the other sub-pixel regions other than the first sub-pixel region.

2. The OLED unit according to claim 1, wherein the color filter layer is formed on the other sub-pixel regions.

3. The OLED unit according to claim 2, wherein the color filter layer is formed on some of the other sub-pixel regions.

4. The OLED unit according to claim 1, wherein the at least two light-emitting units are stacked to emit white light.

5. The OLED unit according to any one of claims 1-4, wherein the other light-emitting units of the at least two light-emitting units comprise polychromatic light-emitting units.

6. The OLED unit according to any one of claims 1-4, wherein the other light-emitting units of the at least two light-emitting units comprise monochromatic light-emitting units.

7. The OLED unit according to any one of claims 1-4, wherein the first monochromatic light-emitting unit is one of red, green and blue light-emitting units, and the other light-emitting units are monochromatic light-emitting units or polychromatic light-emitting units corresponding to the other two colors.

8. The OLED unit according to claim 7, wherein the first monochromatic light-emitting unit comprises a blue light-emitting unit, and the other light-emitting units of the at least two light-emitting units comprise monochromatic light-emitting units or polychromatic light-emitting units corresponding to red and green.

9. The OLED unit according to claim 1, further comprising:
a charge generation layer for connecting the at least two light-emitting units in series.

10. An OLED display panel comprising the OLED unit according to any one of claims 1-9.

11. An OLED display apparatus comprising the OLED display panel according to claim 10.

12. A method of manufacturing an OLED unit comprising a plurality of pixel regions, the method comprising steps of:
forming a first monochromatic light-emitting unit on a first electrode layer, so that the first monochromatic light-emitting unit is located throughout the pixel region to emit light at a first sub-pixel region within the pixel region;
forming other light-emitting units stacked on the first monochromatic light-emitting unit, so that the other light-emitting units correspond to the other sub-pixel regions other than the first sub-pixel region;
forming a second electrode layer on the other light-emitting units and the first monochromatic light-emitting unit, on which no the other light-emitting units are stacked; and
forming a color filter layer on a surface of the first electrode layer or the second electrode layer.

13. The method according to claim 12, wherein the first monochromatic light-emitting unit is formed on the first electrode layer by an opened mask.

14. The method according to any one of claims 12-13, wherein the other light-emitting units are stacked on the first monochromatic light-emitting unit by a high-precision metal mask.

15. The method according to any one of claims 12-13, further comprising steps of:
forming a charge generation layer on the first monochromatic light-emitting unit, and forming the other light-emitting units on the charge generation layer.

16. The method according to any one of claims 12-13, wherein the color filter layer is formed on the other sub-pixel regions.
